# EUROPEAN PATENT APPLICATION

(11) **EP 4 379 791 A1**
(43) Date of publication of application: **05.06.2024**
(21) Application number: 23212548.4
(22) Date of filing: 28.11.2023
(51) Int. Cl.: H01L 23/16, H01L 23/31, H01L 21/56, H01L 21/60

(54) **CORELESS SUBSTRATE PACKAGE AND FABRICATION METHOD THEREOF**

(30) Priority: 30.11.2022 US 202263385443 P; 06.11.2023 US 202318502105
(71) Applicant: MediaTek Inc., Hsin-Chu 300 (TW)
(72) Inventor: TSAO, Pei-Haw, 30078 Hsinchu City (TW); WONG, Te-Chi, 30078 Hsinchu City (TW)
(74) Representative: Hoefer & Partner Patentanwälte mbB

(57) **Abstract**

A coreless substrate package (1) includes a coreless substrate (20); a package device (10) mounted on the coreless substrate (20); an underfill material (310) filling into a space between the package device (10) and the coreless substrate (20); a stiffener ring (40) disposed on a top surface (20a) of the coreless substrate (20) along perimeter of the coreless substrate (20); and a gap fill material (50) disposed in a gap between the stiffener ring (40) and the package device (10).

## Description

### Cross Reference to Related Applications

This application claims the benefit of U.S. Provisional Application No. 63/385,443, filed on November 30th, 2022. The content of the application is incorporated herein by reference.

### Background

The present disclosure relates generally to the field of semiconductor packaging. More particularly, the present disclosure relates to a coreless substrate package and a method for making the same.

As known in the art, Chip-on-Wafer-on-Substrate (CoWoS) is a 2.5D wafer-level multi-chip packaging technology that incorporates multiple dies side-by-side on a silicon interposer substrate in order to achieve better interconnect density and performance. Individual chips are bonded through micro-bumps on the silicon interposer substrate forming a chip-on-wafer (CoW). The CoW is then subsequently thinned such that the through substrate via (TSV) perforations are exposed. C4 bumps formation and singulation are then carried out. A CoWoS package is completed through bonding to a package substrate.

The core of the package substrate is typically made of woven glass layers pre-impregnated with an epoxy resin material, such as the prepreg laminate FR-4 commonly used for printed circuit boards. Connection pads and conductive copper traces are then formed on the core to provide the interconnection between the die and the system to which it is mounted. Using a core material increases the thickness of the package substrate which also increases the profile of the overall package thickness, and the routing between the upper layers and lower signal layers also get longer due to the thickness of the core material.

### Summary

It is one object of the present disclosure to provide a coreless substrate package in order to solve the prior art deficiencies or shortcomings.

A coreless substrate package according to the invention is defined in independent claim 1. The dependent claims define preferred embodiments thereof. One aspect of the present disclosure provides a coreless substrate package including a coreless substrate; a package device mounted on a coreless substrate, wherein the package device comprises a function silicon die, wherein the function silicon die has an active front side facing downwardly to the coreless substrate, and an exposed, passive rear side opposite to the active front side, wherein the package device further comprises an encapsulant covering peripheral sidewalls of the function silicon die; an underfill material filling into a space between the package device and the coreless substrate; a stiffener ring disposed on a top surface of the coreless substrate along perimeter of the coreless substrate; and a gap fill material disposed in a gap between the stiffener ring and the package device.

Preferably, the coreless substrate has a dimension of greater than 45mm × 45mm.

Preferably, a distance between an inner sidewall surface of the stiffener ring and a sidewall surface of the package device is not less than 10 mm.

Preferably, the coreless substrate comprises at least one insulating layer and conductive layers in the at least one insulating layer.

Preferably, the at least one insulating layer comprises Ajinomoto Build-up Film (ABF), polyimide, or prepreg.

Preferably, the conductive layers comprise copper.

Preferably, the conductive layers comprise connection pads exposed from the top surface of the coreless substrate and ball grid array (BGA) ball pads disposed at a bottom surface of the coreless substrate.

Preferably, the package device is mounted on the top surface of the coreless substrate in a flip-chip fashion and is electrically connected to the connection pads through a plurality of C4 bumps
Preferably, BGA balls are disposed on the BGA ball pads, respectively.

Preferably, the coreless substrate does not include a permanent core structure.

Preferably, the stiffener ring is coplanar with the package device and is affixed onto the top surface of the coreless substrate by using an adhesive layer.

Preferably, the gap fill material comprises a molding compound.

Preferably, the gap fill material and the underfill material have different compositions.

Preferably, the gap fill material and the encapsulant have different compositions.

Preferably, the gap fill material has a top surface that is flush with a top surface of the stiffener ring, a top surface of the encapsulant, and the passive rear surface of the function silicon die.

Preferably, the package device comprises a Chip-on-Wafer package or a fan-out package.

Preferably, the function silicon die comprises a System on Chip (SoC) die, an RF die, or an application processor (AP) die.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary coreless substrate package according to an embodiment of the invention; and
FIG. 2 to FIG. 8 are schematic diagrams showing an exemplary method of making the coreless substrate package in FIG. 1.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

The present disclosure pertains to a coreless substrate package with a big package size (substrate dimension greater than 45mm × 45mm). Coreless substrates are preferred for their superior electrical performance and thin profile compare to conventional substrates with core. However, one major concern with coreless substrates is warpage control. The instant invention addresses this issue.

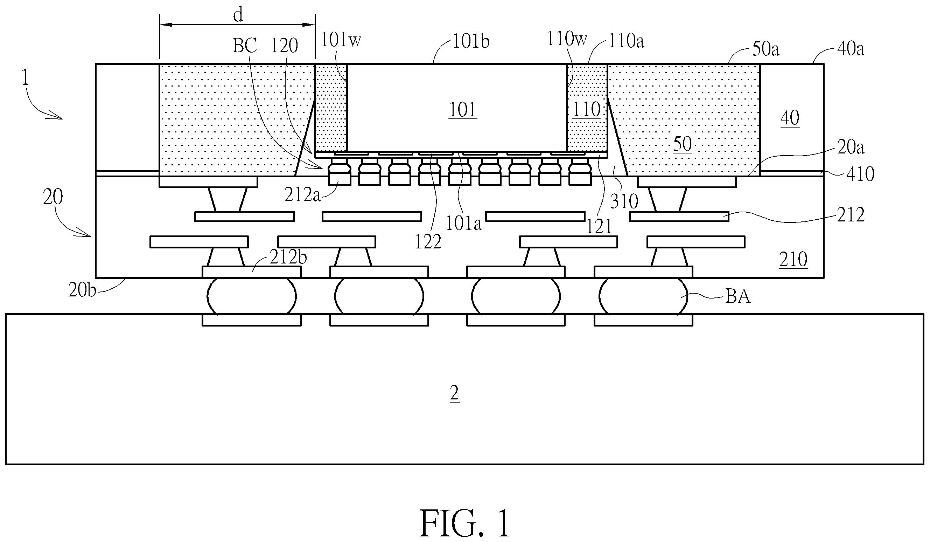

Please refer to FIG. 1, which is a schematic, cross-sectional diagram showing an exemplary coreless substrate package according to an embodiment of the invention. As shown in FIG. 1, the coreless substrate package 1 comprises a package device 10 mounted on a coreless substrate 20 in a flip-chip fashion. Preferably, the package device 10 may comprise a Chip-on-Wafer (CoW) package or a fan-out package including, but not limited to, a function silicon die 101. Preferably, for example, the function silicon die 101 may comprise a System on Chip (SoC) die, an RF die, or an application processor (AP) die, but not limited thereto.

Preferably, the function silicon die 101 has an active front side 101a facing downwardly to the coreless substrate 20, and an exposed, passive rear side 101b opposite to the active front side 101a. Preferably, the peripheral sidewalls 101w of the function silicon die 101 are covered with an encapsulant 110.

In a case that the package device 10 is a fan-out package, for example, a re-distribution layer (RDL) structure 120 may be formed on the active front side 101a and the encapsulant 110. Preferably, for example, the RDL structure 120 may comprise a dielectric layer 121 and metal interconnect structures 122 in or on the dielectric layer 121. Preferably, for example, the dielectric layer 121 may comprise silicon oxide or silicon nitride, but not limited thereto. Preferably, for example, the metal interconnect structures 122 may comprise copper, tungsten, aluminum, titanium, titanium nitride, but not limited thereto.

Preferably, the coreless substrate 20 has a dimension of greater than 45mm × 45mm and may comprise at least an insulating layer 210 and conductive layers 212 in the insulating layer 210. Preferably, the coreless substrate 20 does not include a permanent core structure. Preferably, for example, the insulating layer 210 may comprise Ajinomoto Build-up Film (ABF), polyimide, prepreg, or any suitable build-up film materials, but not limited thereto. Preferably, for example, the conductive layers 212 may comprise copper, but not limited thereto. Preferably, for example, the conductive layers 212 may be formed by electroplating methods, but not limited thereto.

Preferably, for example, the conductive layers 212 may comprise connection pads 212a exposed from the top surface 20a of the coreless substrate 20 and ball grid array (BGA) ball pads 212b disposed at the bottom surface 20b of the coreless substrate 20. Preferably, for example, the package device 10 is mounted on the top surface 20a of the coreless substrate 20 in a flip-chip fashion and may be electrically connected to the connection pads 212a through a plurality of C4 bumps BC comprising, for example, copper and solder. The coreless substrate package 1 may be mounted on a system board or a mother board 2 through a plurality of BGAballs BA formed on the BGAball pads 212b, respectively.

Preferably, for example, the space between the package device 10 and the coreless substrate 20 may be filled with an underfill material 310. The C4 bumps BC are surrounded by the underfill material 310. To cope with the warpage problem of the coreless substrate package 1, a stiffener ring 40 such as a metal ring is disposed on the top surface 20a of the coreless substrate 20 along the perimeter of the coreless substrate 20. Preferably, for example, the stiffener ring 40 is coplanar with the package device 10 and may be affixed onto the top surface 20a of the coreless substrate 20 by using an adhesive layer 410. Preferably, for example, the distance d between the inner sidewall surface of the stiffener ring 40 and the sidewall surface of the package device 10 is not less than 10 mm.

Preferably, for example, a gap fill material 50 such as molding compound or an underfill material is disposed in the gap between the stiffener ring 40 and the package device 10. Preferably, for example, the gap fill material 50 and the underfill material 310 may have different compositions. Preferably, for example, the gap fill material 50 and the encapsulant 110 may have different compositions. Preferably, for example, the gap fill material 50 may have a top surface 50a that is flush with the top surface 40a of the stiffener ring 40, the top surface 110a of the encapsulant 110, and the passive rear surface 101b of the function silicon die 101.

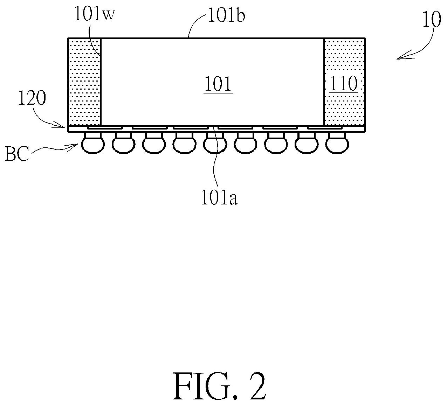

FIG. 2 to FIG. 8 are schematic diagrams showing an exemplary method of making the coreless substrate package in FIG. 1. As shown in FIG. 2, a package device 10 is provided. Preferably, the package device 10 may comprise a Chip-on-Wafer (CoW) package or a fan-out package including, but not limited to, a function silicon die 101. Preferably, for example, the function silicon die 101 may comprise a System on Chip (SoC) die, an RF die, or an application processor (AP) die, but not limited thereto. Preferably, the function silicon die 101 has an active front side 101a facing downwardly and an exposed, passive rear side 101b.

Preferably, the peripheral sidewalls 101w of the function silicon die 101 are covered with an encapsulant 110. In a case that the package device 10 is a fan-out package, for example, a re-distribution layer (RDL) structure 120 may be formed on the active front side 101a and the encapsulant 110. C4 bumps BC comprising copper and solder may be formed on the RDL structure 120 for further connection purposes.

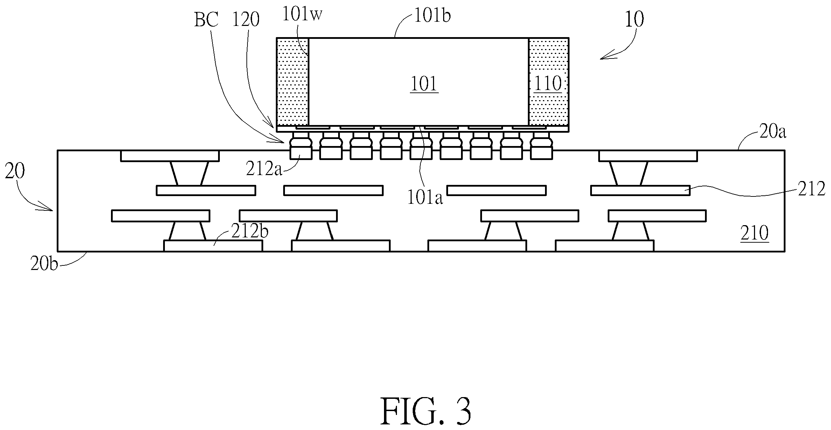

As shown in FIG. 3, the package device 10 is mounted on a coreless substrate 20 in a flip-chip fashion. Preferably, the coreless substrate 20 has a dimension of greater than 45mm × 45mm and may comprise at least an insulating layer 210 and conductive layers 212 in the insulating layer 210. Preferably, the coreless substrate 20 does not include a permanent core structure. Preferably, for example, the insulating layer 210 may comprise Ajinomoto Build-up Film (ABF), polyimide, prepreg, or any suitable build-up film materials, but not limited thereto. Preferably, for example, the conductive layers 212 may comprise copper, but not limited thereto. Preferably, for example, the conductive layers 212 may be formed by electroplating methods, but not limited thereto.

Preferably, for example, the conductive layers 212 may comprise connection pads 212a exposed from the top surface 20a of the coreless substrate 20 and ball grid array (BGA) ball pads 212b disposed at the bottom surface 20b of the coreless substrate 20. Preferably, for example, the package device 10 is mounted on the top surface 20a of the coreless substrate 20 in a flip-chip fashion and may be electrically connected to the connection pads 212a through the C4 bumps BC.

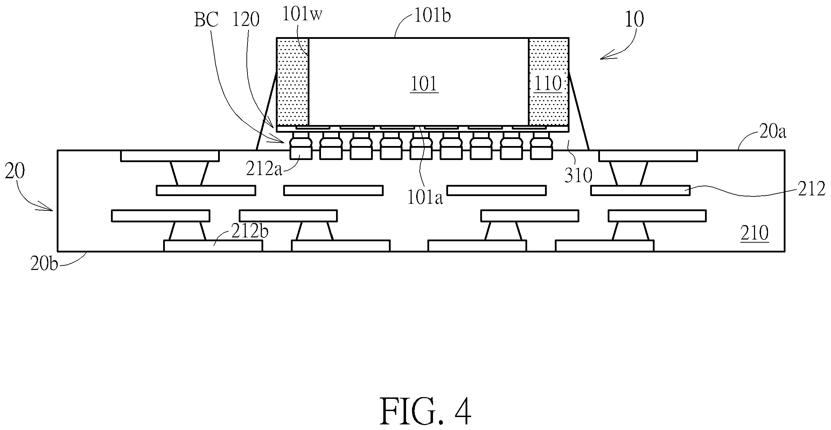

As shown in FIG. 4, the space between the package device 10 and the coreless substrate 20 may be filled with an underfill material 310. The C4 bumps BC are surrounded by the underfill material 310.

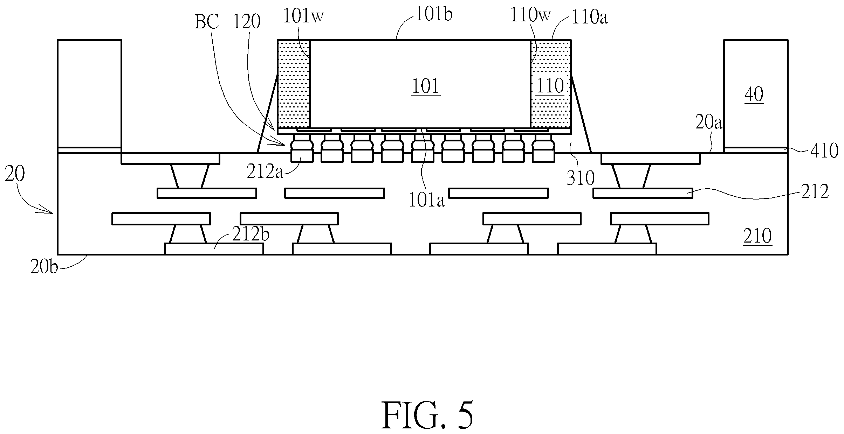

As shown in FIG. 5, a stiffener ring 40 such as a metal ring is disposed on the top surface 20a of the coreless substrate 20 along the perimeter of the coreless substrate 20. Preferably, for example, the stiffener ring 40 is coplanar with the package device 10 and may be affixed onto the top surface 20a of the coreless substrate 20 by using an adhesive layer 410.

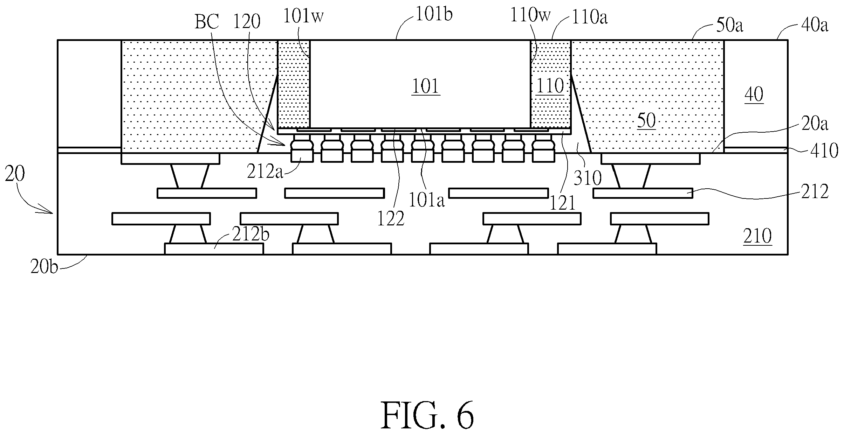

As shown in FIG. 6, a gap fill material 50 such as molding compound or underfill material is disposed in the gap between the stiffener ring 40 and the package device 10. Preferably, for example, the gap fill material 50 and the underfill material 310 may have different compositions. Preferably, for example, the gap fill material 50 and the encapsulant 110 may have different compositions. Preferably, for example, the gap fill material 50 may have a top surface 50a that is flush with the top surface 40a of the stiffener ring 40, the top surface 110a of the encapsulant 110, and the passive rear surface 101b of the function silicon die 101.

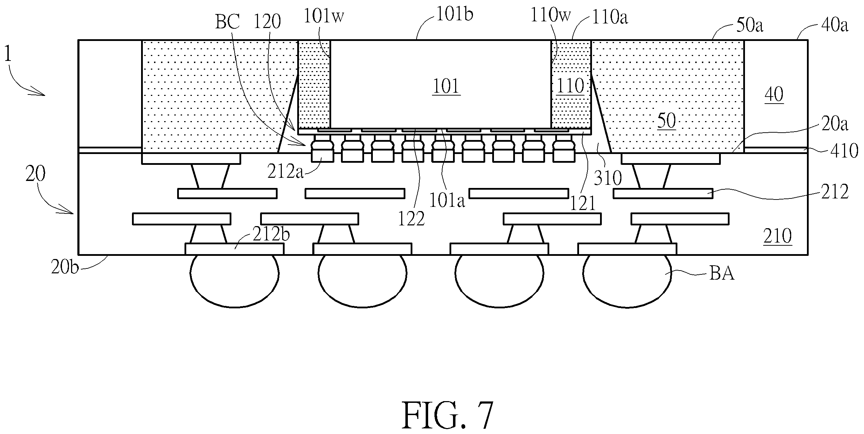

As shown in FIG. 7, subsequently, BGAballs BA are formed on the BGAball pads 212b, respectively, thereby forming coreless substrate package 1.

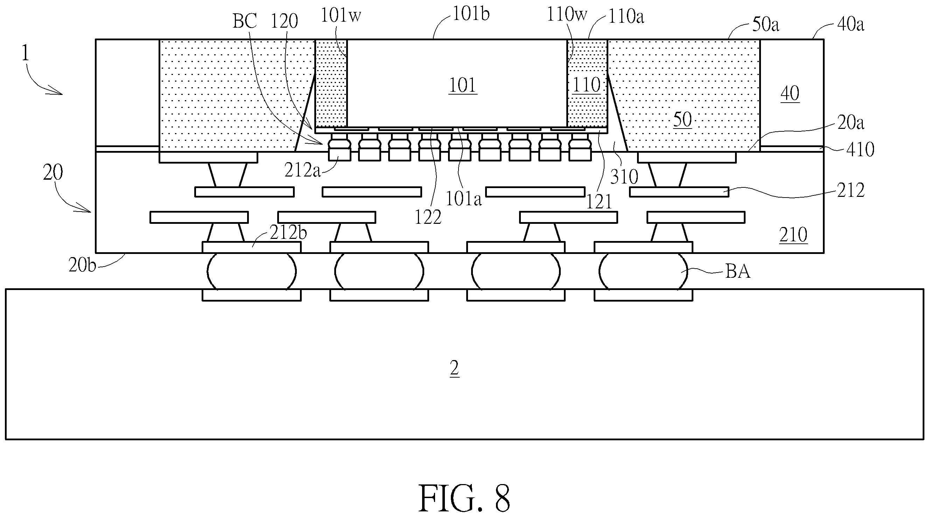

As shown in FIG. 8, subsequently, the coreless substrate package 1 may be mounted on a system board or a mother board 2 through the BGA balls BA by using surface mount techniques.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A coreless substrate package (1), comprising:
a coreless substrate (20);
a package device (10) mounted on the coreless substrate (20), wherein the package device (10) comprises a function silicon die (101), wherein the function silicon die (101) has an active front side (101a) facing downwardly to the coreless substrate (20), and an exposed, passive rear side (101b) opposite to the active front side (101a), wherein the package device (10) further comprises an encapsulant (110) covering peripheral sidewalls (101w) of the function silicon die (101);
an underfill material (310) filling into a space between the package device (10) and the coreless substrate (20);
a stiffener ring (40) disposed on a top surface (20a) of the coreless substrate (20) along perimeter of the coreless substrate (20); and
a gap fill material (50) disposed in a gap between the stiffener ring (40) and the package device (10).

2. The coreless substrate package (1) according to claim 1, wherein the coreless substrate (20) has a dimension of greater than 45mm × 45mm.

3. The coreless substrate package (1) according to claim 1 or 2, wherein a distance (d) between an inner sidewall surface of the stiffener ring (40) and a sidewall surface of the package device (10) is not less than 10 mm.

4. The coreless substrate package (1) according to any one of claims 1 to 3, wherein the coreless substrate (20) comprises at least one insulating layer (210) and conductive layers (212) in the at least one insulating layer (210).

5. The coreless substrate package (1) according to claim 4, wherein the at least one insulating layer (210) comprises Ajinomoto Build-up Film, in the following also referred to as ABF, polyimide, or prepreg.

6. The coreless substrate package (1) according to claim 4 or 5, wherein the conductive layers (212) comprise copper.

7. The coreless substrate package (1) according to any one of claims 4 to 6, wherein the conductive layers (212) comprise connection pads (212a) exposed from the top surface (20a) of the coreless substrate (20) and ball grid array, in the following also referred to as BGA, ball pads (212b) disposed at a bottom surface (20b) of the coreless substrate (20).

8. The coreless substrate package (1) according to claim 7, wherein the package device (10) is mounted on the top surface (20a) of the coreless substrate (20) in a flip-chip fashion and is electrically connected to the connection pads (212a) through a plurality of C4 bumps.

9. The coreless substrate package (1) according to claim 7 or 8, wherein BGAballs are disposed on the BGA ball pads (212b), respectively.

10. The coreless substrate package (1) according to any one of claims 1 to 9, wherein the coreless substrate (20) does not include a permanent core structure.

11. The coreless substrate package (1) according to any one of claims 1 to 10, wherein the stiffener ring (40) is coplanar with the package device (10) and is affixed onto the top surface (20a) of the coreless substrate (20) by using an adhesive layer (410).

12. The coreless substrate package (1) according to any one of claims 1 to 11, wherein the gap fill material (50) comprises a molding compound; and/or
wherein the gap fill material (50) and the underfill material (310) have different compositions; and/or
wherein the gap fill material (50) and the encapsulant (110) have different compositions.

13. The coreless substrate package (1) according to any one of claims 1 to 12, wherein the gap fill material (50) has a top surface (50a) that is flush with a top surface (40a) of the stiffener ring (40), a top surface (110a) of the encapsulant (110), and the passive rear surface (101b) of the function silicon die (101).

14. The coreless substrate package (1) according to any one of claims 1 to 13, wherein the package device (10) comprises a Chip-on-Wafer package or a fan-out package.

15. The coreless substrate package (1) according to any one of claims 1 to 14, wherein the function silicon die (101) comprises a System on Chip, in the following also referred to as SoC, die, an RF die, or an application processor, in the following also referred to as AP, die.
